# EUROPÄISCHE PATENTSCHRIFT

(11) **EP 1 723 684 B1**
(45) Veröffentlichungstag und Bekanntmachung des Hinweises auf die Patenterteilung: **22.12.2010**
(21) Anmeldenummer: 05716775.1
(22) Anmeldetag: 23.02.2005
(51) Int. Cl.: H01L 41/053

(54) **VERFAHREN ZUR ANORDNUNG EINES KONTAKTPINS FÜR EIN PIEZOELEMENT SOWIE HÜLSE UND AKTOREINHEIT**
METHOD FOR MOUNTING A CONTACT PIN FOR A PIEZOELECTRIC ELEMENT, SLEEVE, AND ACTUATOR UNIT
PROCEDE DE MONTAGE D'UNE BROCHE DE CONTACT POUR UN ELEMENT PIEZO-ELECTRIQUE, DOUILLE ET UNITE D'ACTIONNEUR

(30) Priorität: 10.03.2004 DE 102004011697
(43) Veröffentlichungstag der Anmeldung: 22.11.2006
(73) Patentinhaber: Continental Automotive GmbH, 30165 Hannover (DE)
(72) Erfinder: ADAM, Marko, 09126 Chemnitz (DE); DÖLLGAST, Bernd, 91054 Erlangen (DE); SANFTLEBEN, Emanuel, 93102 Pfatter (DE)
(86) Internationale Anmeldenummer: PCT/EP2005/050774
(87) Internationale Veröffentlichungsnummer: WO 2005/088744

(56) Entgegenhaltungen:
- EP-A- 0 485 995
- WO-A-98/47188
- WO-A-2004/004021
- WO-A-2005/035972
- DE-C1- 19 715 488

## Beschreibung

Die Erfindung betrifft nach Anspruch 1 ein Verfahren zur Anordnung wenigstens eines Kontaktpins an einer Hülse, insbesondere einer Kunststoffhülse, in die ein Piezoelement eingefügt wird. Am unteren Ende der Hülse ist am äußeren Umfang eine Pinlagerung für den Kontaktpin vorgesehen. Der Kontaktpin ist dabei über einen oder mehrere Kontaktdrähte mit dem Piezoelement elektrisch verbunden. Die Pinlagerung ist als Rastverbindung ausgebildet, wobei die Rastverbindung derart ausgeführt ist, dass der Kontaktpin nach seiner Einführung in die Rastverbindung in seiner Position fixiert ist. Ein solches Verfahren ist in der nachveröffentlichten WO 2005/035972 A offenbart, die aber lediglich Stand der Technik nach A.54 (3) EPÜ ist. Des weiteren betrifft die Erfindung nach Anspruch 8 eine Hülse zur Aufnahme eines Piezoelementes, das innerhalb der Hülse gelagert ist. Am äußeren Umfang der Hülse sind parallel zur Längsachse der Hülse zwei sich gegenüberliegende Kontaktpins angeordnet, die mittels Kontaktdrähten elektrisch mit dem Piezoelement verbunden sind. Ferner betrifft die Erfindung nach Anspruch 11 einen piezoelektrischen Aktor, der zur Steuerung einer Ventileinheit verwendbar ist, die sich in einem Kraftstoffinjektor befindet.

Bei der Anordnung der Kontaktstifte am äußeren Rand der Hülse besteht das Problem, dass die Kontaktstifte möglichst sicher fixiert werden, damit sie beim nachfolgenden Vergießen der Hülse und dem eingefügten Piezoelement mit Silikon oder einem ähnlichen Material nicht ihre Position verändern. Die exakte Einhaltung einer vorgegebenen Position ist jedoch unbedingt erforderlich, damit die Kontaktpins mit ihren oberen Kontaktflächen nach dem Einbau der Aktoreinheit in den Kraftstoffinjektor für den Anschluss eines elektrischen Steuergerätes gut zugänglich sind. Ferner muss sichergestellt sein, dass die Anschlussteile noch einen genügend großen Isolationsabstand zu benachbarten Metallteilen aufweisen, da an dem Aktor eine relativ hohe Steuerspannung angelegt wird. Eine weitere Schwierigkeit besteht auch darin, dass die Montage der Kontaktpins, an die die Kontaktdrähte zum Piezoelement bereits angelötet sind, etwas mühsam ist, da die Kontaktpins nur sehr lose in den vorgesehenen Bohrungen gehalten werden und daher beim Zusammenfügen der Teile leicht verrutschen können.

Bisher wurden diese Probleme nur unzureichend gelöst. Beispielsweise wurde aus fertigungstechnischen Gründen eine zweiteilige Kunststoffhülse verwendet, die oben und unten über das Piezoelement gestülpt wurde. Durch das Zusammenfügen der beiden Hülsenteile ist die Hülse mechanisch relativ instabil, insbesondere lassen sich die beiden Kontaktpins nur sehr ungenau positionieren. Des weiteren erhöht sich der Aufwand für den Zusammenbau. Auch sind die beiden Kontaktpins am äußeren Rand der Kunststoffhülse in Bohrungen eingeführt, die an der oberen Stirnfläche der Kunststoffhülse angebracht sind. Bei dieser Art der Haltung sind die Kontaktpins relativ beweglich angeordnet, so dass sich beim Vergießen ihre Position leicht ändern kann. Dieses kann dann an der fertig vergossenen Aktoreinheit zu Fehlstellungen der Kontaktpins führen, die nicht mehr korrigierbar sind. Im schlimmsten Fall ist dann die Aktoreinheit nicht verwendbar und auszusortieren.

Der Erfindung liegt die Aufgabe zu Grunde, die Kontaktpins auf einfache Weise am äußeren Rand der Hülse in ihrer Position zu fixieren und dabei den Zusammenbau der Aktoreinheit zu vereinfachen. Diese Aufgabe wird mit den Merkmalen der nebengeordneten Ansprüche 1, 8 und 11 gelöst. Hierbei sind sowohl am oberen Ende der Hülse wie auch an deren unterem Ende eine als Rastverbindung ausgebildete Pinlagerung vorgesehen.

Bei dem erfindungsgemäßen Verfahren zur Anordnung wenigstens eines Kontaktpins an einer Hülse, in der ein Piezoelement eingefügt ist, mit den Merkmalen des Anspruchs 1 beziehungsweise bei der Hülse nach Anspruch 8 und dem piezoelektrischen Aktor nach Anspruch 11 ergibt sich der Vorteil, dass der wenigstens eine Kontaktpin von einer Pinlagerung aufgenommen wird, die als Rastverbindung ausgebildet ist. Durch die Rastverbindung erhält der Kontaktpin einen sicheren Halt und ist so auf einfache Weise gegen ein Verschieben in axialer oder radialer Richtung fixiert. Als besonders vorteilhaft wird dabei angesehen, dass der Kontaktpin seitlich eingeklipst werden kann. Dieses erleichtert die Einführung des Kontaktpins erheblich, da der Kontaktpin in der Regel mit vielen dünnen Kontaktdrähten verlötet ist, die an ihrem zweiten Ende mit dem Piezoelement verbunden sind. Diese Kontaktdrähte sind sehr empfindlich und können bei unvorsichtiger Handhabung leicht brechen.

Bei dem piezoelektrischen Aktor erscheint besonders vorteilhaft, dass die Hülse einteilig ausgebildet ist. Sie kann beispielsweise mit entsprechender Festigkeit leicht im Spritzgussverfahren hergestellt werden. Die Hülse ist dadurch formstabil, ist leicht zu handhaben, so dass die Kontaktpins in den Rastverbindungen sicher fixiert werden können.

Durch die in den abhängigen Ansprüchen aufgeführten Maßnahmen sind vorteilhafte Weiterbildungen und Verbesserungen des in den nebengeordneten Ansprüche 1, 8 und 11 angegebenen Verfahrens beziehungsweise der Hülse und dem piezoelektrischen Aktor gegeben. Eine besondere günstige Lösung wird darin gesehen, dass am äußeren Rand der Hülse eine obere Pinlagerung vorgesehen ist, die eine Einführhilfe aufweist. Diese Einführhilfe ist keilförmig ausgebildet, so dass der Kontaktpin auf sehr einfache Weise seitlich eingeführt und verrastet werden kann. Durch die Verrastung wird der Kontaktpin ist seiner Position besonders sicher fixiert.

Als vorteilhaft wird auch die Lösung angesehen, das bei einer unteren Pinlagerung eine Auflage vorgesehen ist, durch die der Kontaktpin gegen Druck von oben gesichert ist. Gleichzeitig dient die Auflage in vorteilhafter Weise als Isolierung gegen sich darunter befindliche Metallteile.

Um auch an der unteren Pinlagerung ein leichtes Einführen des Kontaktpins zu erreichen, ist eine Führungshilfe vorgesehen. Dadurch kann der Kontaktpin ähnlich wie bei er oberen Pinlagerung seitlich eingeführt und verrastet werden. Das erleichtert die Montage des Kontaktpins, insbesondere wenn der Kontaktpin bereits mit den vielen Kontaktdrähten verbunden ist.

An der unteren Pinlagerung ist bei einem bevorzugten Ausführungsbeispiel des weiteren eine Arretierung vorgesehen. Die Arretierung ist vorzugsweise als Noppe ausgebildet und verhindert somit, dass der Kontaktpin an seinem untern Ende aus der Arretierung herausrutschen kann.

Die Arretierungen für den Kontaktpin sind als lösbare oder alternativ als nicht lösbare Rastverbindungen ausgebildet. Die Hülse ist dadurch für verschiedene Anwendungsfälle universell verwendbar, insbesondere lassen sich dadurch auch Reparaturversuche durchführen.

Ein Ausführungsbeispiel der Erfindung ist in der Zeichnung dargestellt und wird in der nachfolgenden Beschreibung näher erläutert.
- Figur 1: zeigt in dreidimensionaler Darstellung eine erfin- dungsgemäße einteilige Hülse,
- Figur 2: zeigt eine Draufsicht zu der in Figur 1 dargestell- ten Hülse,
- Figur 3: zeigt als räumliche Darstellung, wie zwei Kontakt- pins an der Hülse befestigt werden können,
- Figur 4: zeigt die Hülse mit den verrasteten beiden Kontakt- pins in räumlicher Darstellung,
- Figur 5: zeigt in Draufsicht ein Piezoelement mit Kontakt- drähten, die mit den beiden Kontaktpins verbunden sind,
- Figur 6: zeigt das Piezoelement mit den beiden verdrahteten Kontaktpins in dreidimensionaler Darstellung und
- Figur 7: zeigt die einteilige Hülse mit dem montierten Pie- zoelement, zwei Kontaktpins und den Kontaktdrähten in dreidimensionaler Darstellung vor dem Vergießen.

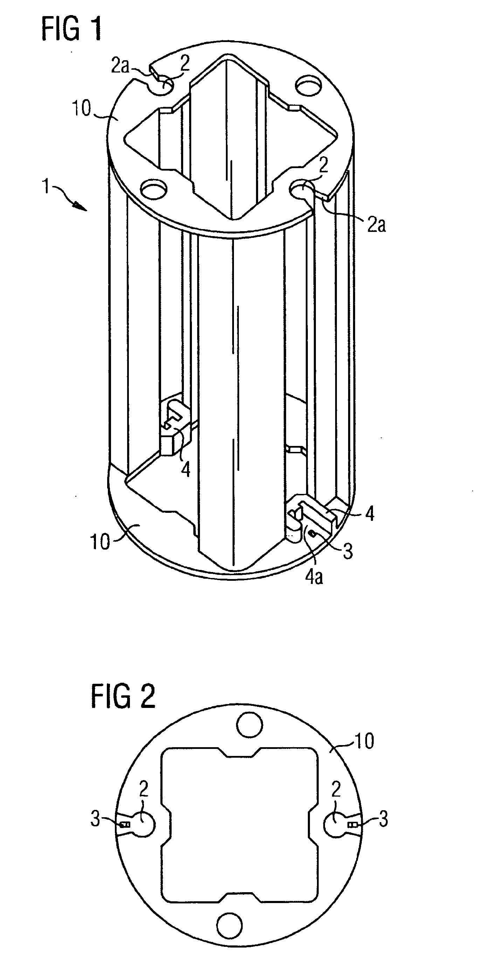

In Figur 1 ist entsprechend einem Ausführungsbeispiel der Erfindung eine Hülse 1 in dreidimensionaler Darstellung gezeichnet, die als Montagehülse zur Aufnahme eines entsprechend ausgebildeten Piezoelementes ausgeformt ist, wie später noch näher erläutert wird. Die Hülse 1 ist vorzugsweise aus einem isolierenden Kunststoff im Spritzgussverfahren hergestellt. Wie Figur 1 weiter entnehmbar ist, ist die Hülse 1 einteilig ausgeformt, so dass sie mit entsprechender Passgenauigkeit und formstabil gefertigt werden kann. An zwei gegenüberliegenden Stirnflächen 10 der Hülse 1 sind quadratisch geformte durchgehende Aussparungen vorgesehen, die zur Aufnahme des Piezoelementes dienen. Des weiteren besitzt die Hülse 1 zwei sich gegenüberliegende seitliche Öffnungen. Diese Öffnungen sind so groß ausgebildet, dass durch sie das Piezoelement geschoben werden kann. An der oberen Stirnfläche 10 sind am äußeren Rand der Hülse 1 zwei sich gegenüberliegende Bohrungen angebracht, die als Pinlagerungen 2 für die Kontaktpins dienen. Die Pinlagerungen 2 weisen zum äußeren Rand der Stirnfläche 10 gerichtete keilförmige Einführhilfen 2a auf, durch die die Kontaktpins leichter in die Pinlagerungen 2 eingeführt werden können. Die Pinlagerungen 2 sind bezüglich ihres Durchmessers und der keilförmigen Einführhilfen 2a als Rastverbindungen ausgeführt und stellen sicher, dass die Kontaktpins nach dem Einschieben in ihrer Position sicher fixiert sind. Die beiden Pinlagerungen 2 befinden sich vorzugsweise in einem Bereich der Hülse 1, an dem keine seitlichen Öffnungen vorgesehen sind.

Sind die Kontaktpins - beispielsweise um die Polaritäten für die Stromzuführung unterscheidbar zu machen - mit unterschiedlich dickem Durchmesser ausgebildet, dann sind auch die Rastverbindungen 2 entsprechend angepasst. Des weiteren können die Kontaktpins im Bereich der Rastverbindungen mit Einschnürungen oder einem Wulst ausgebildet sein, um ein vertikales Verschieben der Kontaktpins zu verhindern.

An der unteren Stirnfläche 10 der Hülse 1 sind passend zu den beiden oberen Pinlagerungen zwei weitere Pinlagerungen 2 vorgesehen. Diese beiden Pinlagerungen 2 sind an der Innenseite der Stirnfläche 10 als erhabene Kontur angespritzt. Sie sind nach außen hin offen ausgebildet und bilden für die einzuführenden Kontaktpins eine Führungshilfe 4. An der Öffnung der beiden Führungshilfen 4 ist eine Arretierung 3 vorgesehen, die im einfachsten Fall als erhabene Kontur (Noppe) ausgebildet ist. Sie ist vorzugsweise keilförmig ausgebildet, um ein leichtes Einrasten des Kontaktpins zu ermöglichen, das Herausfallen jedoch zu verhindern.

Die zuvor beschriebenen Rastverbindungen 2 können derart ausgebildet sein, dass sie lösbar - oder in alternativer Ausgestaltung der Erfindung - nicht lösbar sind.

An der Hülse 1 sind beispielsweise weitere Bohrungen vorsehbar, die zur Befestigung weiterer Teile, beispielsweise einer Rohrfeder verwendet werden können.

In Figur 2 ist die zuvor beschriebene Hülse 1 in Draufsicht dargestellt. Zu erkennen ist die quadratisch ausgeformte Öffnung zur Aufnahme des Piezoelementes, die sich in der Mitte der Stirnfläche 10 befindet. Am äußeren Umfang sind links und rechts in Figur 2 zwei sich gegenüberliegende Rastverbindungen 2 erkennbar. Des weiteren sind die Arretierungen 3 erkennbar, die an der unteren Stirnfläche 10 angebracht sind. Es sei noch erwähnt, dass die dargestellte Hülse 1 nicht maßstäblich gezeichnet ist.

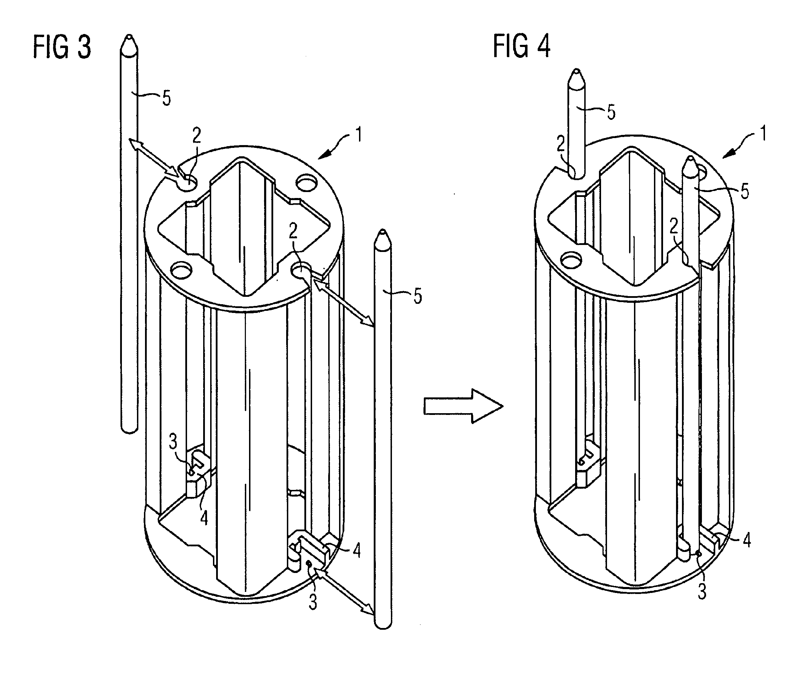

Die beiden Figuren 3 und 4 zeigen, wie die Kontaktpins 5 an der Hülse 1 angeordnet und montiert werden. Die beiden Kontaktpins 5 sind im einfachsten Fall als Stifte (Metallstifte), Rohr oder dergleichen ausgebildet und werden - wie durch die beiden Pfeile in Figur 3 dargestellt ist - in die Pinlagerungen beziehungsweise Rastverbindungen 2 von der Seite her eingeführt und eingeklipst und hier so verrastet, dass ihre Position relativ zur Hülse 1 fixiert ist. Die beiden Kontaktpins 5 werden dabei so eingeführt, dass ihr unteres Ende auf der unteren Stirnfläche 10 aufliegt und von der Arretierung 3 fixiert wird. Die Montage der Kontaktstifte 5, an die das die Kontaktdrähte und das Piezoelement bereits angelötet wurde, wird noch nachfolgend genauer erläutert.

In Figur 4 sind die beiden Kontaktpins 5 im montierten Zustand dargestellt. Aus Übersichtlichkeitsgründen ist diese Darstellung vereinfacht ausgeführt. In der Praxis ist vorgesehen, dass die beiden Kontaktpins 5 zuvor mit einer Vielzahl von Kontaktdrähten verlötet sind, die die elektrischen Verbindungen zum Piezoelement herstellen. Das verdrahtete Piezoelement muss also zusammen mit den beiden Kontaktpins 5 gleichzeitig in der Hülse 1 eingesetzt werden. Das Piezoelement wird dabei zusammen mit einem Kontaktpin durch eine der beiden seitlichen Öffnungen so hindurchgeschoben, dass es in der quadratischen Aussparung Platz findet. Der eine Kontaktpin wird dabei ganz durchgeschoben. Wenn sich das Piezoelement in der gewünschten Position befindet, dann werden die Kontaktdrähte so um die Hülse 1 geführt, dass die beiden Kontaktpins 5 in die vorgesehenen Rastverbindungen 2 eingeklipst werden können.

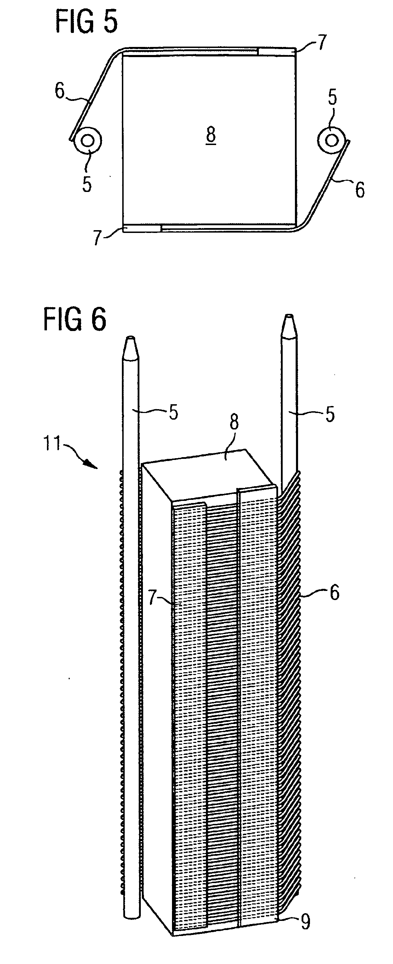

Figur 5 zeigt ein Piezoelement 8 in Draufsicht. Das Piezoelement 8 ist aus einer Vielzahl einzelner Piezo-Keramikscheiben in Form eines Quaders als sogenanntes Piezostack zusammengefügt. An zwei gegenüberliegende Kanten des Piezoelementes 8 ist jeweils eine Elektrode 7 angebracht, die mit den einzelnem Scheiben des Piezostacks kontaktiert sind. Rechts und links vom Piezoelement 8 sind die beiden Kontaktpins 5 im Querschnitt erkennbar. Zwischen einer Elektrode 7 und einem Kontaktpin 5 sind die Kontaktdrähte 6 gewickelt. Die Kontaktdrähte 6 sind dabei um eine Ecke des Piezoelementes 8 geführt. Um einem elektrischen Kurzschluss mit dem Piezoelement 8 zu vermeiden, ist jeweils ein Kantenschutz 9 vorgesehen, wie in Figur 6 erkennbar ist. Die vielen Kontaktdrähte 6 sind vorgesehen, um bei einem Bruch der Elektroden 7, die wegen der ständigen Längenänderungen des Piezoelementes 8 sehr stark belastet werden, eine Unterbrechung des elektrischen Stromkreises zu verhindern.

Figur 6 zeigt die Aktoreinheit 11 mit den Kontaktpins 5, dem Kantenschutz 9 und den Kontaktdrähten 6 in dreidimensionaler Darstellung. Die Kontaktpins 5 sind in dieser Form über die Kontaktdrähte 6 flexibel mit dem Piezoelement 8 verbunden.

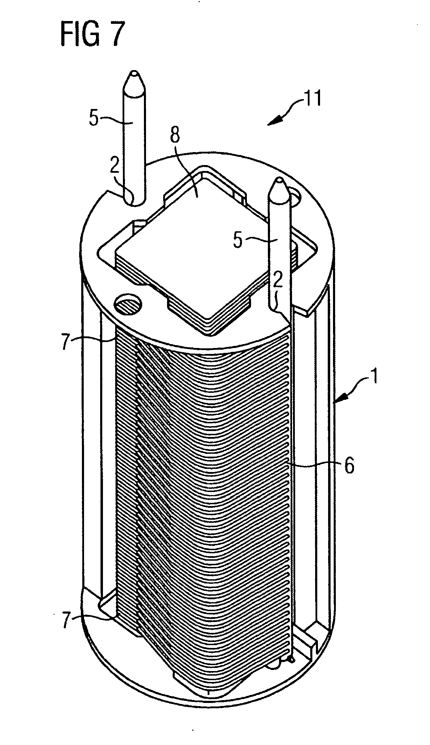

Figur 7 zeigt einen piezoelektrischen Aktor, der als Aktoreinheit 11 fertig montiert ist. Bei der Aktoreinheit 11 wurde das Piezoelement 8 in die einteilige Hülse 1 eingesetzt, wie zuvor beschrieben. Des weiteren sind die beiden Kontaktpins 5 in die Rastverbindungen 2 eingeklipst. Die oberen freistehenden Enden der beiden Kontaktpins 5 dienen für die spätere elektrische Verbindung zu dem Steuergerät. Auch sind die vielen Kontaktdrähte 6 erkennbar, die an der Elektrode 7 an entsprechenden Lötflächen angelötet sind. In diesem Zustand ist der piezoelektrische Aktor 11 für den Verguss fertig vorbereitet.

## Patentansprüche

1. Verfahren zur Anordnung wenigstens eines Kontaktpins (5) an einer Hülse (1), insbesondere einer Kunststoffhülse, in die ein Piezoelement (8) eingeführt wird, wobei am oberen und am unteren Ende der Hülse (4) an ihrem äußeren Umfang für den Kontaktpin (5) wenigstens eine Pinlagerung (2) vorgesehen ist, und wobei der Kontaktpin (5) über einen oder mehrere Kontaktdrähte (6) mit dem Piezoelement (8) kontaktiert wird, wobei die Pinlagerungen (2) als Rastverbindungen ausgebildet sind, und wobei die Rastverbindungen derart ausgeführt sind, dass der Kontaktpin (5) nach seiner Einführung in die Rastverbindungen (2) in seiner Position fixiert ist.

2. Verfahren nach Anspruch 1, **dadurch gekennzeichnet, dass** am äußeren Rand der Hülse (1) eine obere Pinlagerung (2) vorgesehen ist und dass die obere Pinlagerung (2) eine keilförmige Einführhilfe (2a) aufweist, durch die der Kontaktpin (5) zur Verrastung seitlich in die Pinlagerung (2) einführbar ist.

3. Verfahren nach einem der vorhergehenden Ansprüche, **dadurch gekennzeichnet, dass** die untere Pinlagerung (2) eine Auflage (4a) aufweist und dass die Auflage (4a) den Kontaktpin (5) gegen Druck von oben sichert.

4. Verfahren nach einem der vorhergehenden Ansprüche, **dadurch gekennzeichnet, dass** die untere Pinlagerung (2) eine Führungshilfe (4) aufweist, durch die der Kontaktpin (5) seitlich in die Hülse (1) einführbar ist.

5. Verfahren nach einem der vorhergehenden Ansprüche, **dadurch gekennzeichnet, dass** die untere Pinlagerung (2) eine Arretierung (3) aufweist, die vorzugsweise als Noppe ausgebildet ist und dabei das untere Ende des Kontaktpins (5) gegen ein Herausfallen aus der Führungshilfe (4) sichert.

6. Verfahren nach einem der vorhergehenden Ansprüche, **dadurch gekennzeichnet, dass** die Rastverbindunen (2) für den Kontaktpin (5) lösbar ausgebildet sind.

7. Verfahren nach einem der Ansprüche 1 bis 5, **dadurch gekennzeichnet, dass** die Rastverbindungen (2) für den Kontaktpin (5) unlösbar ausgebildet sind.

8. Hülse zur Aufnahme eines Piezoelementes (8), wobei das Piezoelement (8) innerhalb der Hülse (1) gelagert ist, wobei am äußeren Umfang der Hülse (1) parallel zur Längsachse zwei sich gegenüberliegende Kontaktpins (5) angeordnet sind, die mittels mehrerer Kontaktdrähte (6) ein in der Hülse (1) befindliches Piezoelement (8) kontaktieren, und wobei die Hülse (1) an ihrer oberen und ihrer unteren Stirnfläche (10) zur Fixierung der beiden Kontaktpins (5) jeweils zwei Pinlagerungen (2) aufweist und wobei die Pinlagerungen (2) als Rastverbindungen ausgebildet sind.

9. Hülse nach Anspruch 8, **dadurch gekennzeichnet, dass** die Rastverbindungen (2) der Hülse (1) eine keilförmige Einführhilfe (2a) und/oder Führungshilfe (4) aufweisen, durch die der Kontaktpin (5) seitlich einführbar ist.

10. Hülse nach einem der Ansprüche 8 oder 9, **dadurch gekennzeichnet, dass** die Hülse (1) einteilig und als Kunststoffhülse ausgebildet ist.

11. Piezoelektrischer Aktor zur Steuerung einer Ventileinheit eines Kraftstoffinjektors, wobei der piezoelektrische Aktor (11) ein Piezoelement (8) aufweist, das von einer Kunststoffhülse (1) umgeben ist und wobei das Piezoelement (8) über Kontaktdrähte (6) mit zwei Kontaktpins (5) verbunden ist, die am äußeren Rand der Kunststoffhülse (1) angeordnet sind, wobei die Kunststoffhülse (1) als einteiliger Hohlkörper ausgeformt ist und wobei die Kunststoffhülse (1) an einer oberen und einer unteren Stirnfläche (10) integrierte Rastverbindungen (2) aufweist, durch die die Kontaktpins (5) in ihrer Position fixierbar sind.

## Claims

1. Method for disposing at least one contact pin (5) on a sleeve (1), in particular a plastic sleeve, into which a piezo element (8) is inserted, wherein at least one pin mount (2) is provided for the contact pin (5) on the outer circumference at the upper and lower end of the sleeve (4) and wherein the contact pin (5) is connected electrically by way of one or more contact wires (6) to the piezo element (8), the pin mounts (2) being configured as detent connections and the detent connections being embodied such that the contact pin (5) is fixed in its position after insertion into the detent connections.

2. Method according to claim 1, **characterised in that** an upper pin mount (2) is provided on the outer edge of the sleeve (1) and that the upper pin mount (2) has a wedge-shaped insertion aid (2a) by means of which the contact pin (5) can be inserted laterally into the pin mount (2) to lock into position.

3. Method according to one of the preceding claims, **characterised in that** the lower pin mount (2) has a support (4a) and that the support (4a) secures the contact pin (5) against pressure from above.

4. Method according to one of the preceding claims, **characterised in that** the lower pin mount (2) has a guide aid (4) by means of which the contact pin (5) can be inserted laterally into the sleeve (1).

5. Method according to one of the preceding claims, **characterised in that** the lower pin mount (2) has an arresting element (3), which is preferably configured as a stud and thereby prevents the lower end of the contact pin (5) from falling out of the guide aid (4).

6. Method according to one of the preceding claims, **characterised in that** the detent connections (2) for the contact pin (5) are configured as releasable.

7. Method according to one of claims 1 to 5, **characterised in that** the detent connections (2) for the contact pin (5) are configured as non-releasable.

8. Sleeve for accommodating a piezo element (8), the piezo element (8) being mounted inside the sleeve (1), wherein two contact pins (5) lying opposite one another are disposed on the outer circumference of the sleeve (1) parallel to the longitudinal axis and are connected electrically by means of a plurality of contact wires (6) to a piezo element (8) situated in the sleeve (1), the sleeve (1) having two pin mounts (2) respectively at its upper and its lower end face (10) for fixing the two contact pins (5) and the pin mounts (2) being configured as detent connections.

9. Sleeve according to claim 8, **characterised in that** the detent connections (2) of the sleeve (1) have a wedge-shaped insertion aid (2a) and/or guide aid (4) by means of which the contact pin (5) can be inserted laterally.

10. Sleeve according to one of claims 8 or 9, **characterised in that** the sleeve (1) is configured as a single piece and as a plastic sleeve.

11. Piezoelectric actuator for controlling a valve unit of a fuel injector, the piezoelectric actuator (11) having a piezo element (8) which is surrounded by a plastic sleeve (1) and the piezo element (8) being connected by way of contact wires (6) to two contact pins (5) which are disposed on the outer edge of the plastic sleeve (1), the plastic sleeve (1) being formed as a single-piece hollow body and the plastic sleeve (1) having integrated detent connections (2) on an upper and a lower end face (10), by means of which the contact pins (5) can be fixed in their position.

## Revendications

1. Procédé pour l'agencement d'au moins une broche de contact (5) sur une douille (1), en particulier une douille en matière plastique, dans laquelle sera introduit un élément piézoélectrique (8), au moins un logement de broche (2) pour la broche de contact (5) étant prévu à l'extrémité supérieure et à l'extrémité inférieure de la douille (1) sur sa périphérie extérieure, et la broche de contact (5) étant mise en contact avec l'élément piézoélectrique (8) par un ou plusieurs fils de contact (6), les logements de broche (2) étant réalisés sous forme de fixations par clipsage et les fixations par clipsage étant réalisées de telle sorte que la broche de contact (5) est bloquée en position après son introduction dans les fixations par clipsage (2).

2. Procédé selon la revendication 1, **caractérisé en ce que** sur le bord extérieur de la douille (1) est prévu un logement de broche (2) supérieur et **en ce que** le logement de broche (2) supérieur comporte un guide d'introduction (2a) conique, à travers lequel la broche de contact (5) peut être introduite latéralement dans le logement de broche (2) en vue de son clipsage.

3. Procédé selon l'une quelconque des revendications précédentes, **caractérisé en ce que** le logement de broche (2) inférieur comporte un support (4a) et **en ce que** le support (4a) immobilise la broche de contact (5) contre toute pression exercée depuis le dessus.

4. Procédé selon l'une quelconque des revendications précédentes, **caractérisé en ce que** le logement de broche (2) inférieur comporte un guidage (4) à travers lequel la broche de contact (5) peut être introduite latéralement dans la douille (1).

5. Procédé selon l'une quelconque des revendications précédentes, **caractérisé en ce que** le logement de broche (2) inférieur comporte un élément d'arrêt (3), qui est réalisé de préférence sous forme de picot et, en l'occurrence, immobilise l'extrémité inférieure de la broche de contact (5) pour l'empêcher de tomber hors du guidage (4).

6. Procédé selon l'une quelconque des revendications précédentes, **caractérisé en ce que** les fixations par clipsage (2) pour la broche de contact (5) sont réalisées de manière amovible.

7. Procédé selon l'une quelconque des revendications 1 à 5, **caractérisé en ce que** les fixations par clipsage (2) pour la broche de contact (5) sont réalisées de manière non amovible.

8. Douille destinée à recevoir un élément piézoélectrique (8), ledit élément piézoélectrique (8) étant logé à l'intérieur de la douille (1), sachant que sur le bord extérieur de la douille (1) sont disposées deux broches de contact (5) opposées qui, par l'intermédiaire de plusieurs fils de contact (6), sont mises en contact avec l'élément piézoélectrique (8) disposé dans la douille (1), et la douille (1) comportant respectivement deux logements de broche (2) au niveau de ses faces frontales (10) supérieure et inférieure pour la fixation des deux broches de contact (5), et les logements de broche (2) étant réalisés sous la forme de fixations par clipsage.

9. Douille selon la revendication 8, **caractérisée en ce que** les fixations par clipsage (2) de la douille (1) comportent un guide d'introduction (2a) conique et/ou un guidage (4), par lesquels la broche de contact (5) peut être introduite latéralement.

10. Douille selon la revendication 8 ou 9, **caractérisée en ce que** la douille (1) est réalisée en une seule pièce et sous forme de douille en matière plastique.

11. Actionneur piézoélectrique destiné à commander une unité de soupapes d'un injecteur de carburant, ledit actionneur piézoélectrique (11) comportant un élément piézoélectrique (8), qui est entouré par une douille (1) en matière plastique et ledit élément piézoélectrique (8) étant relié, par l'intermédiaire de fils de contact (6), à deux broches de contact (5) qui sont disposées sur le bord extérieur de la douille (1) en matière plastique, ladite douille (1) en matière plastique étant configurée sous forme de corps creux en une seule pièce, et la douille (1) en matière plastique comportant des fixations par clipsage (2), qui sont intégrées dans ses faces frontales (10) supérieure et inférieure et par lesquelles les broches de contact (5) sont peuvent être bloquées en position.
